Europäisches Patentamt

European Patent Office

Office européen des brevets

(11) Publication number: **0 245 677 B1**

# EUROPEAN PATENT SPECIFICATION

(45) Date of publication of patent specification: **29.07.92**     (51) Int. Cl.⁵: **H05K 3/34**

(21) Application number: **87105988.7**

(22) Date of filing: **24.04.87**

(54) A method of soldering.

(30) Priority: **05.05.86 US 859974**

(43) Date of publication of application:
**19.11.87 Bulletin 87/47**

(45) Publication of the grant of the patent:
**29.07.92 Bulletin 92/31**

(84) Designated Contracting States:
**DE FR GB IT**

(56) References cited:
**US-A- 3 851 223**
**US-A- 4 216 350**

**IBM TECHNICAL DISCLOSURE BULLETIN, vol. 13, no. 8, January 1971, page 2320, New York, US; D.A. KOOP et al.: "Etched braze preform sheet"**

(73) Proprietor: **International Business Machines Corporation**
**Old Orchard Road**
**Armonk, N.Y. 10504(US)**

(72) Inventor: **Seaman, Ronald Joseph**
**7007 Danwood Drive**
**Austin Texas 78759(US)**
Inventor: **Vanderlee, Keith Allan**
**5302 Marsh Creek Drive**
**Austin§Texas 78759(US)**

(74) Representative: **Bailey, Geoffrey Alan**
**IBM United Kingdom Limited Intellectual Property Department Hursley Park**
**Winchester Hampshire SO21 2JN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 245 677 B1

## Description

This invention relates to a method of soldering an electronic component to a printed circuit substrate.

Conventional methods for assembling modules such as pin grid arrays in a surface soldered or reflow soldered package require either fluxing and then placement of individual solder preforms on each pad of the array or an additional wave soldering operation following the reflow soldering required for other surface mount devices.

The prior art offers many ways of applying solder to a plurality of sites. For example, U.S. -A- 4,216,350 discloses the use of a web of non-fusible material having a plurality of apertures homologous with those of terminals to he soldered to a circuit board to hold within the respective apertures of individual solder rings. The web loaded with the rings permits disposition of a large number of solder rings at one time upon the corresponding terminals.

U.S. -A- 3,396,894 discloses an applicator for simultaneous application of a plurality of solder bodies or other heat fusible material. The applicator contains the plurality of solder bodies disposed in individual heat recoverable cups.

IBM Technical Disclosure Bulletin, Vol. 13, No. 8, January 1971, page 2320 to Koop et al discloses an etched braze preform sheet for brazing solder bucket connectors to metallised ceramic circuit module substrates. The preform comprises a sheet of brazing alloy stock with portions etched away leaving preforms not strongly connected to each other, these preforms corresponding to metallised pad locations on the ceramic module.

None of these references addresses the particular problems associated with attaching pin grid array modules or other multi-leaded modules to plated through holes or surface amount pads in a printed circuit substrate being soldered in a reflow soldering process. For example, Koop et al requires the application of the brazing material followed by another operation to attach pins or the like. The aforementioned US -A- 3,396,894 teaches one time application of solder to connect a plurality of pins to a printed circuit substrate, but requires the removal of the applicator only after the solder has cooled. The aforementioned US -A- 4,216,350 requires placing the individual solder preforms into a carrier web.

The present invention seeks to provide an improved method of soldering an electronic component to a printed circuit board.

The invention provides a method of soldering an electronic component to a printed circuit substrate comprising: forming a multipad solder preform of predetermined thickness with a plurality of perforations in a pattern complementing the pattern of leads or pins on the component; fluxing the preform; sandwiching the preform between the component and the printed circuit substrate so as to align the component leads or pins, non-perforated preform areas, and lands or through holes in the substrate, and reflowing the solder.

The solder preform has apertures stamped in a predetermined pattern corresponding to the module leads and mounting pads or plated through holes (PTH) in the printed circuit substrate. The preform is sandwiched between the substrate and the module to be attached, fluxed and reflowed. When the solder preform melts separation at the perforations occurs. Surface tension and solder wetting cause the solder near any given module lead to flow to that lead and the pad or PTH on which that lead rests. A predetermined amount of solder flows to each lead and pad or plated through hole location.

Liquid flux appropriate to the solder composition is applied before the reflow operation. The solder preform may be properly located with respect to the module and its associated pads or PTHs by providing the preform with undersized, that is smaller than the pins on the module, holes at two or more corner pin locations. An interference fit results from slightly forcing the locating holes in the preform over the associated pins on the module to be attached.

Solder volume available at any given pin location is determined by selecting the thickness of the preform as a function of hole size and shape and lead size and shape required, solder fillet size, and pad size and shape. The perforations are stamped in the preform in a pattern selected as a function of the volume of solder required, pin location and density, and presence of circuit lines between the pads.

How the invention can be carried out will now be described by way of example, with reference to the accompanying drawings, in which:

Fig. 1 is an exploded view of a pinned grid array module in alignment with a multiple pad preform adjacent a section of a printed circuit substrate;

Fig. 2 is an exploded view of a module with gull wing leads, a solder preform and a portion of a printed circuit substrate;

Fig. 3 is a top view of the multipad preform shown in Fig. 2;

Fig. 4 is a schematic top view of a preform used with leaded components; and

Fig. 5 is a schematic illustration of the relationship of solder fillet to module lead to plated through hole or pad size.

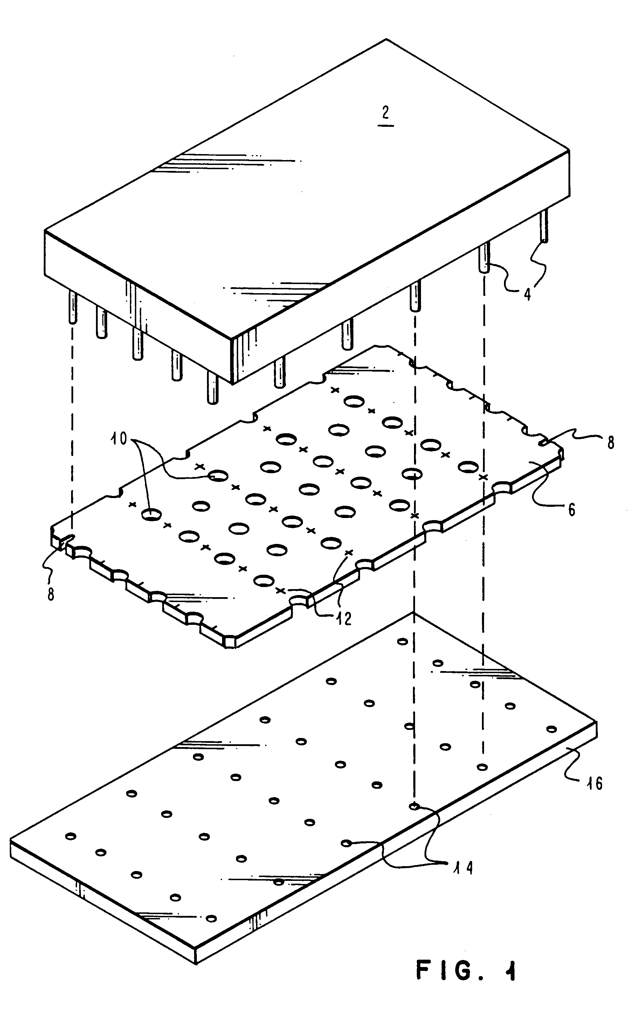

In Fig. 1 pin grid array module 2 has pin leads 4 which are required to be reliably attached to a printed circuit substrate 16. Solder preform 6 is provided optionally with two undersized holes 8 which are an interference fit with corner ones of pins 4 in module 2 for proper alignment. Additionally, a pattern of perforations 10 of a predetermined diameter is provided in solder preform 6. The x's 12 represent the centres of the solder areas which will form a bond with pins 4 and the pads or plated through holes (PTH) 14 in the printed circuit substrate 16.

The perforations 8 and 10 in preform 6 may be formed using a conventional mechanical punch. It will be understood by those skilled in the art that dies corresponding in size, shape and location to the predetermined hole pattern are required.

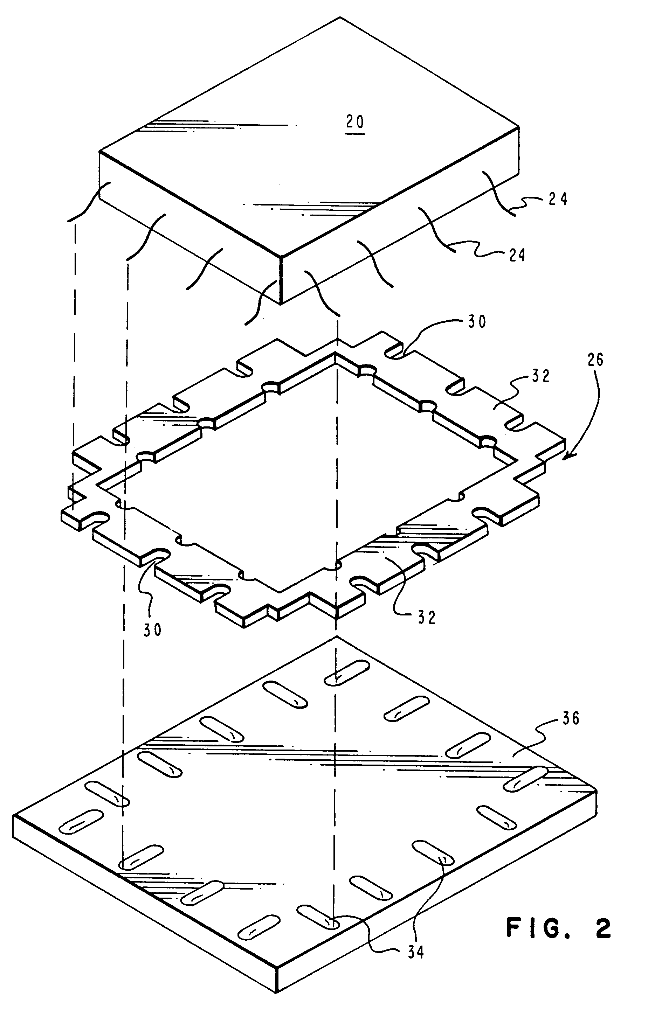

Fig. 2 is similar to Fig. 1 and shows an application of the invention to surface mount technology. Module 20 is a plastic leaded chip carrier (PLCC) or other flat pack device having gull wing leads 24. Solder preform 26 has punched out areas 30 adjacent solid areas corresponding to the locations of leads 24 which are also in alignment with surface mount pads 34 in printed circuit substrate 36.

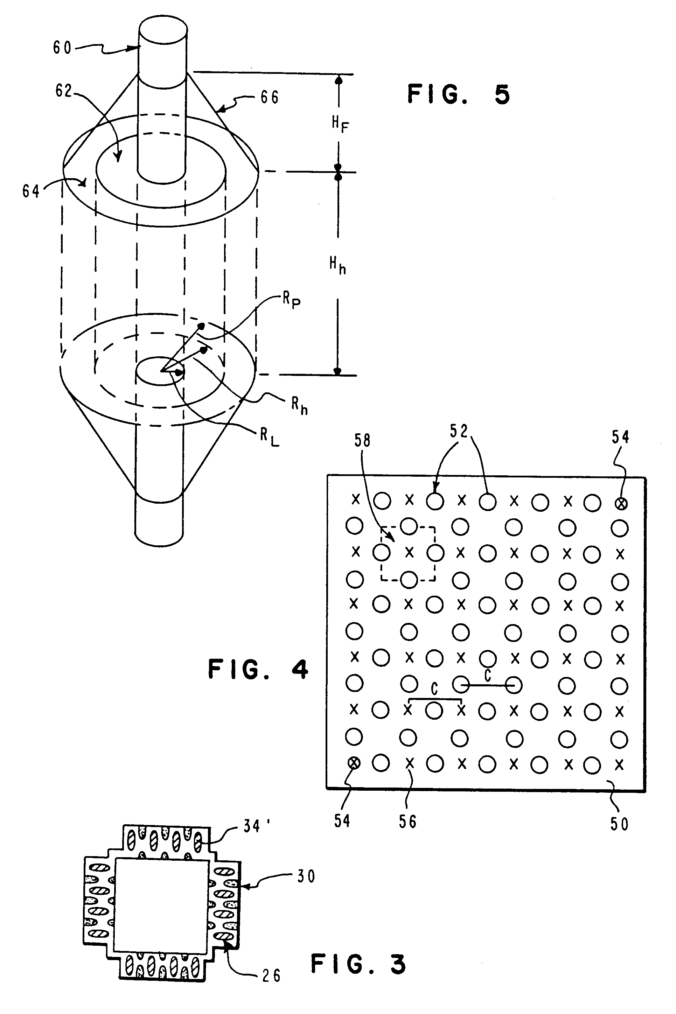

Fig. 3 is a top view of the multipad preform 26 shown in Fig. 2 and indicates the geometric relationship between the punched out areas 30 and surface mount pads 34.

The process of the present invention involves for choosing the preform thickness and perforation pattern as a function of component dimensions, printed circuit substrate geometry and desired solder fillet dimensions. Conventional techniques are used for forming that pattern. The preform is then sandwiched between the component to be attached and the circuit board in proper alignment which may be facilitated with the use of locating holes. It is to be noted that the preform may be fluxed before it is placed on the printed circuit board. A reflow solder operation follows, and as the preform 6 or 26 (Figs. 1 and 2) becomes molten it separates at holes 10 or cut away areas 30. Surface tension causes the solder near any given pin 4 or lead 24 to flow thereto and the pad 14 or plated through hole 34.

It is very critical to properly choose the thickness of the preform and size of the holes in the preform. The calculation of the appropriate thickness and hole size may be accomplished as described below.

Fig. 4 is a schematic representation of a solder preform 50 in which holes 52 are formed in a pattern surrounding x's 56 representing component lead locations. The maximum size of the holes 52 in preform 50 is given by:

$$S = \frac{\sqrt{2}}{4} C$$

where C = pin to pin spacing which is the same as the hole to hole spacing in the same direction; and
    S =      radius of a hole 52 in the preform.

It is necessary to calculate the volume of solder required to fill the hole, if one is present, cover the pad, and produce fillets on the lead. This calculation involves known variables such as the pin to pin spacing, and the size and shape of the pin, and pad.

The next requirement is the determination of the volume of solder available per lead. This result is a function of the preform thickness and the hole size.

Next, equate the volume of solder required to the volume of solder available. The result is an equation containing the thickness of the preform and the size of the holes as a function of known quantities: the size and shape of the hole, pad, and lead (or pin), and the pin to pin spacing.

It has been found that optimum preform performance occurs when S is chosen to be between 1/3 and 9/10 times its maximum possible value. The thickness is calculated using the equation derived above and the selected value of S.

Generally, solder in sheet form is available in standard sizes. If desired, a standard thickness may be selected and a value of S calculated from the above derived equation. The value of S thus calculated must fall between 1/3 and 9/10 times the thickness selected.

An exemplary determination of multipad preform thickness will be described in connection with Fig. 5 which schematically shows a single cylindrical lead 60, a cylindrical plated through hole 62, a circular pad 64 and a frusto-conical solder fillet 66. Assume the following dimensions for one lead and pad.

$R_L$ =      radius of lead 60
$R_h$ =      radius of PTH 62
$R_p$ =      radius of pad 64
$H_F$ =      height of fillet 66
$H_h$ =      height of hole = thickness of the circuit substrate

Step 1 - calculation of required solder volume

$V_F$ = Volume of solder + lead in one fillet = $(\pi/3)\, H_f(R_L{}^2 + R_p{}^2 + R_L R_p)$
$V_h$ = Volume of solder + lead in PTH = $\pi H_h R_h{}^2$
$V_L$ = Volume of lead covered by solder = $\pi R_L{}^2(H_h + 2H_f)$

There are fillets on both the top and bottom of the card.

Total volume $V_T$ of solder required equals the volume of 2 fillets plus the volume of the PTH less the volume of the lead covered by solder.

$V_T = 2V_F + V_h - V_L$

$2V_F + V_h - V_L = \pi/3\,[2H_F R_p{}^2 + 2H_F R_L R_p + 3H_h(R_h{}^2 - R_L{}^2) - 4H_F R_L{}^2]$

Step 2 - calculation of available preform volume

Refer again to Fig. 4. Each x 56 represents the location of a module pin. Each hole 52 is stamped, punched or otherwise formed in the preform 50. Optional locating holes are indicated at 54. The solder within the dotted square 58 is available to flow toward a pin located at the x 56 at its centre.

The preferred preform geometry is that shown in Fig. 4. Holes 52 are located at sites corresponding to the spaces between adjacent pad or PTH locations in a circuit substrate. As illustrated the preferred ratio of holes to pads/PTHs is 2:1, i.e., there are two holes 52 associated with each x 56.

Let
C = hole to hole centre distance
S = radius of hole 52 cut in preform
T = thickness of preform

The volume $(V_A)$, of solder available at each PTH is a square volume with sides equal to the hole 52 to hole 52 centre distance less the volume of the four half circles at the middle of the sides of this square which have been punched out times the thickness of preform 50.

$VA = [C^2 - 4(1/2\pi S^2)]\,T = [C^2 - 2\pi S^2]T$

Step 3 - equating the available volume $V_A$ with the required volume $V_T$ and solving for the thickness T of the preform.

$$V_A = 2V_F + V_h - V_L$$

$$T = \frac{\pi/3\left[2H_F R_p{}^2 + 2H_F R_L R_p + 3H_h\left(R_h{}^2 - R_L{}^2\right) - 4H_F R_L{}^2\right]}{C^2 - 2\pi S^2}$$

Using this equation, S and T may be calculated. The allowable values S are between 1/3 and 9/10 times the maximum possible value of S. The allowable values of T are restricted only by the thicknesses of solder sheet materials available.

Those skilled in the art will appreciate that similar calculations may be performed for any particular lead, pad, and PTH geometries.

Thus, there has been disclosed herein a simple way of assuring the proper volume of solder to join leads to PTHs or surface pads. For a given card/board population application, the calculation of thickness occurs once as does the design of the die or other means for making the holes in the preform. This technique lends itself to mass production methods for making preforms.

The solder preforms may be placed with accuracy and reliability on circuit board substrates using conventional program controlled placement apparatus.

## Claims

1. A method of soldering an electronic component (2) to a printed circuit substrate (16) comprising:
    forming a multipad solder preform (6) of predetermined thickness with a plurality of perforations

4

(10) in a pattern complementing the pattern of leads or pins (4) on the component;

fluxing the preform;

sandwiching the preform (6) between the component (2) and the printed circuit substrate (16) so as to align the component leads or pins, non-perforated preform areas (12), and lands or through holes (14) in the substrate, and reflowing the solder.

2. A method as claimed in Claim 1, including determining the thickness of the preform, and perforation shape, size and spacing as a function of the component lead or pin size, shape and spacing, dimensions of substrate lands or metallised through holes and desired solder fillet size and shape.

3. A method as claimed in Claim 1 or 2, including providing at least two locating holes (8) in the preform.

4. A method as claimed in any preceding claim, in which the component is provided with pins and the preform has approximately twice as many perforations as the number of pins on the component.

5. A method as claimed in Claim 3, in which the components are provided with pins and the locating holes in the preform are sufficiently small that the component pins cannot enter.

**Revendications**

1. Procédé pour souder un composant électronique (2) sur un substrat à circuits imprimés (16) comprenant :

la formation d'une préforme de soudure (6) à plots multiples, possédant une épaisseur prédéterminée et comportant une pluralité de perforations (10) disposées suivant un réseau complémentaire du réseau de fils ou bornes (4) du composant;

appliquer un flux à la préforme;

enserrer la préforme (6) entre le composant (2) et le substrat à circuits imprimés (16) de manière à aligner les fils ou bornes du composant, des zones non perforées (12) de la préforme et des portées ou des trous traversants (14) ménagés dans le substrat, et faire fondre la soudure.

2. Procédé selon la revendication 1, comprenant la détermination de l'épaisseur de la préforme et de la forme, de la taille et de l'espacement des perforations en fonction de la taille, de la forme et de l'espacement des fils ou des bornes du composant, des dimensions des portées du substrat ou des trous métallisés et de la taille et de la forme désirées des raccords d'angle de soudure.

3. Procédé selon la revendication 1 ou 2, incluant l'aménagement d'au moins deux trous de positionnement (8) dans la préforme.

4. Procédé selon l'une quelconque des revendications précédentes, selon lequel le composant est pourvu de bornes et la préforme possède un nombre de perforations égal approximativement au double du nombre de bornes présentes sur le composant.

5. Procédé selon la revendication 3, selon lequel les composants sont équipés de bornes et les trous de positionnement ménagés dans la préforme sont suffisamment petits pour que les bornes des composants ne puissent pas y pénétrer.

**Patentansprüche**

1. Verfahren zum Löten eines elektronischen Bauteiles (2) auf ein Leiterplattensubstrat (16), welches aufweist:

Ausbilden eines Lotvorformlings (6) mit Vielfachflächen mit vorbestimmter Dicke und mit einer Mehrzahl von Perforationen (10) in einem Muster, welches zu dem Muster von Drähten oder Stiften (4) des Bauteils komplementär ist;

Versehen des Vorformlings mit einem Flußmittel;

Einbetten des Vorformlings (6) zwischen den Bauteil (2) und das Leiterplattensubstrat (16) auf eine solche Weise, daß ein Ausrichten der Bauteildrähte oder -stifte, unperforierten Flächen (12) des Vorformlings und von Kontaktflecken oder Durchgangslöchern (14) in dem Substrat erfolgt, und Aufschmelzen des Lots.

2. Verfahren nach Anspruch 1, welches einschließt, daß die Dicke des Vorformlings und die Form, die Größe und der Abstand der Perforationen in Abhängigkeit von der Abmessung, der Form und dem Abstand der Bauteildrähte oder -stifte, den Abmessungen von Kontaktflächen oder metallisierten Durchgangslöchern des Substrats und von der gewünschten Größe und Gestalt der Loteinlagen bestimmt wird.

3. Verfahren nach Anspruch 1 oder 2, bei welchem in dem Vorformling zumindest zwei Zentrierlöcher (8) vorgesehen werden.

4. Verfahren nach einem der vorgehenden Ansprüche, bei welchem der Bauteil mit Stiften versehen ist und der Vorformling etwa doppelt soviele Perforationen besitzt, als die Stiftanzahl des Bauteils beträgt.

5. Verfahren nach Anspruch 3, bei welchem die Bauteile mit Stiften versehen sind und die Zentrierlöcher in dem Vorformling klein genug sind, um ein Eintreten der Bauteilstifte zu verhindern.

FIG. 1

20

24

24

30

32

26

30

32

36

34

FIG. 2

FIG. 5

FIG. 4

FIG. 3